# EUROPEAN PATENT SPECIFICATION

(11) **EP 0 858 254 B1**
(45) Date of publication and mention of the grant of the patent: **09.04.2003**
(21) Application number: 98300598.4
(22) Date of filing: 28.01.1998
(51) Int. Cl.: H05K 7/18, H02B 1/30

(54) **A shelf**
Ein Regal
Une planche

(30) Priority: 05.02.1997 GB 9702322
(43) Date of publication of application: 12.08.1998
(73) Proprietor: Reddicliffe, Edward A., Lymington, Hants SO41 8PS (GB)
(72) Inventor: Reddicliffe, Edward A., Lymington, Hants SO41 8PS (GB)
(74) Representative: Haley, Stephen

(56) References cited:
- EP-A- 0 401 052
- CA-A- 1 318 343
- GB-A- 2 245 156
- US-A- 2 975 908
- US-A- 5 415 472

## Description

The present invention relates to a shelf for a cabinet, for example used for housing electronic equipment.

In such cabinets, the shelves are usually fastened with nuts, bolts, loose fittings or brackets of some sort. These can fall into sensitive electronic equipment and cause damage. In addition, when the cabinet is of the type which is supported by a post in or near each corner, a shelf which provides a full mounting width across the cabinet cannot normally be removed unless the shelf is tipped to reduce its effective width allowing it to fit between the posts. Tipping is sometimes impossible when the cabinet is densely packed as there is an insufficient gap between the pieces of equipment to tip between the shelf sufficiently. The width of a shelf may therefore have to be reduced to the distance between the mounting posts, thereby reducing the available shelf space within the cabinet and would not actually be possible when the mounting surfaces of the mounting posts are a greater distance apart than the distance between the innermost edges of the mounting posts.

US-A-5415472 discloses a hinged shelf. CA-A-1318343 discloses an extendable shelf. US-A-2975908 discloses a modular shelf.

According to the present invention, there is provided a shelf for a cabinet, the shelf being supportable at both ends in the cabinet and comprising a main body having at least a hinged flap being permanently attached to the main body at one of said ends, the hinged flap being hinged about an axis perpendicular to the width of the shelf, allowing the hinged flap to be moved out of the plane of the main body to cause an effective reduction in the width of the shelf, characterised in that: the hinged flap is arranged such that when it is moved out of the plane of the main body, it does not extend out of the plane of the main body in the direction opposite to that of its movement.

By "width" of the shelf is meant the dimension from one end of the shelf to the other, and not the dimension from the front of the shelf to the back.

Instead of tilting the shelf, the or each flap is simply moved out of the plane of the main body, thereby reducing the effective width of the shelf to a size which will fit between the front posts of the cabinet. Although some tilting may be necessary this will be for less that for a shelf with no flaps. for a shelf with no flaps. As the flap is at the end of the main body of the shelf, the bending moments acting on the hinge when the shelf is loaded are less than they would be for a shelf hinged towards the centre.

Preferably the main body occupies more than 80%, and more preferably more than 90%, and most preferably substantially 92% of the width of the upper surface of the shelf.

Also, if the main body is a unitary member, because the flap is at the end of the shelf, the main body can accommodate a telescopic shelf which is slidable in the direction of the axis of the hinged flap.

The or each flap is preferably permanently attached. Such a shelf has no removable parts, so that there is no danger of any loose fittings falling into the equipment.

If a hinged flap is provided at each end of the shelf, the vertical distance taken up by each flap when the flaps are moved out of the plane of the main body is less than the vertical distance taken by only one flap allowing closer spacing of the shelves.

The or each flap may be movable upwardly or downwardly to reduce the width of the shelf. However, if the or each flap is arranged so that, when the shelf is raised, the flap moves downwardly under gravity, this allows the shelf to be removed simply by raising it, whereupon the or each flap moves downwardly, and sliding it forwards out of the cabinet.

Both ends of the shelf preferably have some means for engaging a support on the cabinet, such as projecting lugs on the or each flap, each of which lugs engages with one of a line of holes in each post. This means is preferably a punched lug, as this provides high strength.

The facing surfaces of the main body and the or each flap preferably abut one another when the shelf is fitted in the cabinet so that the shelf is kept rigid without requiring a catch mechanism between the main body and the or each flap. The interface between the main body and the or each hinged flap is preferably inclined, so that, when the shelf is viewed from the front, the incline is downwards and inwards. This increases the load capacity reduces the deflection of the shelf and provides easy clearance for the radial swing of the flap..

The axis along which the or each flap is hinged to the main body of the shelf is preferably off-set inwardly from the edge of the main body, and the or each flap is preferably provided at each end with a flange, which extends to, and is pivotally supported at the hinge axis. This construction provides a small radius of swing so that the distance between adjacent shelves in a cabinet can be minimised. If the flange is laminar and is provided in a plane perpendicular to the axis of the hinge, it will be very strong in shear when the shelf is loaded.

One example of a shelf constructed in accordance with the present invention will now be described with reference to the accompanying drawing, in which:
Fig. 1 is a diagrammatic perspective view of part of a shelf; and
Fig. 2 is a view showing the detail of one end.

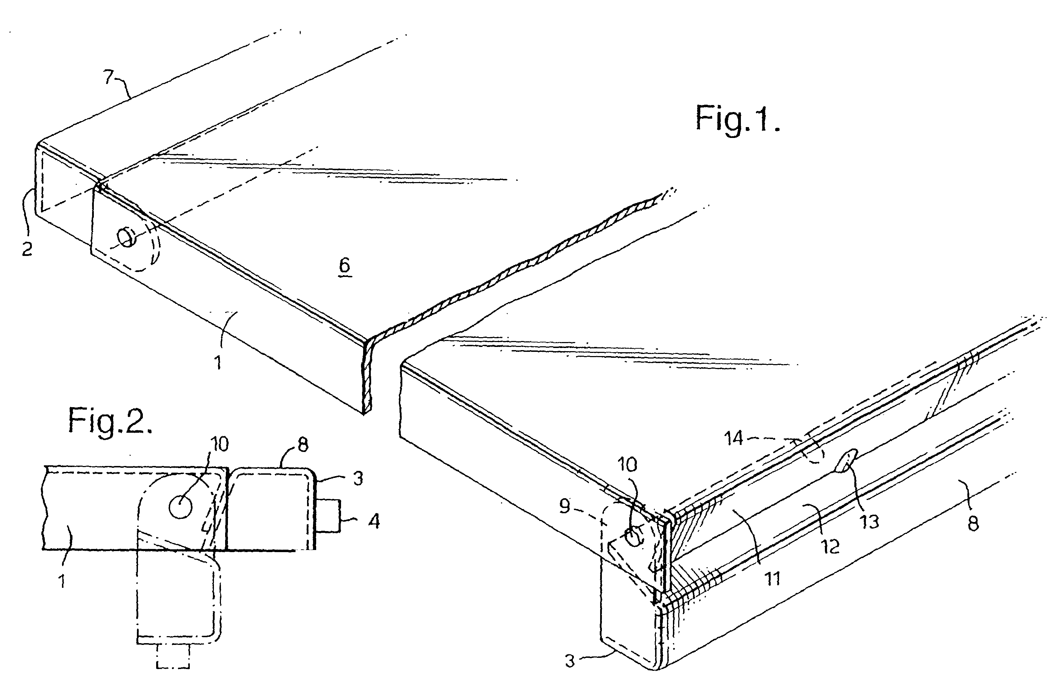

The shelf has a front 1, and two lateral ends 2, 3, at which the shelf is supported in a cabinet by virtue of engagement between punched lugs 4 (as shown in Fig.2) which engage with corresponding holes in the posts of the cabinet.

The shelf comprises a main body 6, at either end of which is provided a hinged flap 7, 8. A flange 9 projects at each end of each hinged flap 7, 8, and is pivotally connected to the main body 6 by hinged joint 10. The flanges 9 are within the main body 6, so that the upper edge of each flange provides an accurate dead stop against the underside of the main body 6, and so as to provide an alternative reference surface to ensure that the main body and flaps rest in a perfectly horizontal position. The facing surfaces 11, 12 of the main body 6 and hinged flaps 7, 8 are inclined downwardly and inwardly.

With both hinged flaps 7, 8 hinged downwardly as shown on the right hand side of the figure, the shelf is slid between the front posts of the cabinet into the cabinet above the support on which it is to rest. The user then moves the two hinged flaps 7, 8 into their upward position as shown on the left hand side of the figure, and lowers the shelf until the lugs 4 engage the holes in the posts at the desired height.

In order to remove the shelf, the main body 6 is lifted, and the hinged flaps 7, 8 move to their downward position under gravity. The shelf can then be slid out of the cabinet between the front posts.

Dimples 13 are provided on the surface 11 of the main body. These provide interference points against areas 14 on the flap when the shelf is in place in the cabinet and give a slight locking effect to prevent the shelves from being too easily knocked out.

## Claims

1. A shelf for a cabinet, the shelf being supportable at both ends in the cabinet and comprising a main body (6) having at least a hinged flap (7,8) being permanently attached to the main body (6) at one of said ends, the hinged flap being hinged about an axis perpendicular to the width of the shelf, allowing the hinged flap to be moved out of the plane of the main body to cause an effective reduction in the width of the shelf (1), **characterised in that**: the hinged flap is arranged such that when it is moved out of the plane of the main body, it does not extend out of the plane of the main body in the direction opposite to that of its movement.

2. A shelf according to claim 1, wherein the main body occupies more than 80%, and preferably more than 90% and more preferably substantially 92% of the width of the upper surface of the shelf.

3. A shelf according to claim 1 or claim 2, wherein the main body (6) is a unitary member.

4. A shelf according to claim 3, wherein the main body can accommodate a telescopic shelf which is slidable in the direction of the axis of the hinged flap (7,8).

5. A shelf according to any one of the preceding claims, wherein a hinged flap (7,8) is provided at each end of the main body.

6. A shelf according to any one of the preceding claims, wherein the or each flap (7,8) is arranged so that, when the shelf is raised, the flap moves downwardly under gravity.

7. A shelf according to any one of the preceding claims, wherein both ends of the shelf have some means (4) for engaging a support on the cabinet.

8. A shelf according to claim 7, wherein the means for engaging a support are punched lugs (4).

9. A shelf according to any one of the preceding claims, wherein the facing surfaces of the main body (6) and the or each flap (7,8) abut one another when the shelf is fitted in the cabinet so that the shelf is kept rigid without requiring a catch mechanism between the main body and the or each flap.

10. A shelf according to claim 9, wherein the interface between the main body (6) and the or each hinged flap (7,8) is inclined, so that, when the shelf is viewed from the front, the incline is downwards and inwards.

11. A shelf according to any one of the preceding claims, wherein the corresponding axis along which the or each flap (7,8) is hinged to the main body (6) of the shelf is off-set inwardly from the edge of the main body, and the or each flap is provided at the hinged end with a flange, which extends to, and is pivotally supported at the corresponding hinge axis.

12. A shelf according to any one of the preceding claims, wherein the main body (6) is provided with protrusions (13) on a surface (11) facing the corresponding flap (7,8) so that the protrusions provide interference points when the shelf is installed in a cabinet.

## Patentansprüche

1. Ein (Fach-)Brett für einen Schrank, wobei das Brett an beiden Enden in dem Schrank lagerbar ist und einen Hauptkörper (6) umfaßt, der mindestens eine schwenkbar gelenkige Klappe (7, 8) umfaßt, die dauerhaft an dem Hauptkörper (6) an einem der genannten Enden befestigt ist, wobei die gelenkige Klappe um eine Achse senkrecht zur Breite des Brettes schwenkbar ist, was es der gelenkigen Klappe ermöglicht, aus der Ebene des Hauptkörpers herausgeschwenkt zu werden, um eine wirksame Verringerung der Breite des Brettes (1) herbeizuführen, **dadurch gekennzeichnet, daß** die gelenkige Klappe so angeordnet ist, daß, sie sich wenn sie aus der Ebene des Hauptkörpers herausbewegt wird, nicht aus der Ebene des Hauptkörpers in der Richtung entgegengesetzt zu ihrer Bewegung erstreckt.

2. Ein Brett nach Anspruch 1, wobei der Hauptkörper mehr als 80 % und vorzugsweise mehr als 90 % und besonders bevorzugt im wesentlichen 92 % der Breite der Oberfläche des Brettes einnimmt.

3. Ein Brett nach Anspruch 1 oder Anspruch 2, wobei der Hauptkörper (6) ein unitäres Teil ist.

4. Ein Brett nach Anspruch 3, wobei der Hauptkörper ein teleskopisches Brett aufnehmen kann, das in Richtung der Achse der schwenkbaren Klappe (7, 8) gleitbar ist.

5. Ein Brett nach einem der vorhergehenden Ansprüche, wobei an jedem Ende des Hauptkörpers eine gelenkige Klappe (7, 8) vorgesehen ist.

6. Ein Brett nach einem der vorhergehenden Ansprüche, wobei die oder jede Klappe (7, 8) so angeordnet ist, daß die Klappe sich, wenn das Brett angehoben wird, unter Schwerkraft nach unten bewegt.

7. Ein Brett nach einem der vorhergehenden Ansprüche, wobei beide Enden des Brettes Mittel (4) zum Angreifen an einem Träger an dem Schrank aufweisen.

8. Ein Brett nach Anspruch 7, wobei die Mittel zum Angreifen an einem Träger ausgestanzte Ansätze oder Ohren (4) aufweisen.

9. Ein Brett nach einem der vorhergehenden Ansprüche, wobei die aufeinanderzu gerichteten Oberflächen des Hauptkörpers (6) und der oder jeder Klappe (7, 8) gegeneinander anliegen, wenn das Brett in den Schrank eingepaßt ist, so daß das Brett ohne die Notwendigkeit eines Verriegelungsmechanismus' starr zwischen dem Hauptkörper und der oder jeder Klappe gehalten ist.

10. Ein Brett nach Anspruch 9, wobei die Zwischenfläche zwischen dem Hauptkörper (6) und der oder jeder gelenkigen Klappe (7, 8) geneigt ist, so daß, wenn man das Brett von vorn betrachtet, die Neigung sich nach unten und innen erstreckt.

11. Ein Brett nach einem der vorhergehenden Ansprüche, wobei die entsprechende Achse, entlang der die oder jede Klappe (7, 8) gelenkig an dem Hauptkörper (6) des Bretts sitzt, nach innen von dem Rand des Hauptkörpers abgesetzt ist und die oder jede Klappe am Anlenkende mit einem Flansch versehen ist, der sich auf die entsprechende Schwenkachse zu erstreckt und daran schwenkbar getragen ist

12. Ein Brett nach einem der vorhergehenden Ansprüche, wobei der Hauptkörper (6) mit Vorsprüngen (13) an einer Oberfläche (11) versehen ist, die der entsprechenden Klappe (7, 8) zugewandt ist, so daß die Vorsprünge für Angriffspunkte sorgen, wenn das Brett in einem Schrank installiert ist.

## Revendications

1. Etagère pour coffret, l'étagère étant destinée à être supportée aux deux extrémités dans le coffret et comprenant un corps principal (6) ayant au moins un rabat articulé (7, 8) qui est fixé de façon permanente au corps principal (6) à l'une des extrémités, le rabat articulé étant articulé autour d'un axe perpendiculaire à la largeur de l'étagère, et permettant au rabat articulé d'être écarté du plan du corps principal pour provoquer une réduction efficace de la largeur de l'étagère (1), **caractérisée en ce que** le rabat articulé est disposé afin que, lorsqu'il est déplacé en dehors du plan du corps principal, il ne s'étende pas en dehors du plan du corps principal en direction opposée à celle de son mouvement.

2. Etagère selon la revendication 1, dans laquelle le corps principal occupe plus de 80 % et de préférence plus de 90 % et très avantageusement environ 92 % de la largeur de la surface supérieure d'étagère.

3. Etagère selon la revendication 1 ou 2, dans laquelle le corps principal (6) est un organe en une seule pièce.

4. Etagère selon la revendication 3, dans laquelle le corps principal permet le logement d'une étagère télescopique qui peut coulisser dans la direction de l'axe du rabat articulé (7, 8).

5. Etagère selon l'une quelconque des revendications précédentes, dans laquelle un rabat articulé (7, 8) est disposé à chaque extrémité du corps principal.

6. Etagère selon l'une quelconque des revendications précédentes, dans laquelle le rabat ou chaque rabat (7, 8) est disposé afin que, lorsque l'étagère est levée, le rabat se déplace vers le bas sous l'action de la pesanteur.

7. Etagère selon l'une quelconque des revendications précédentes, dans laquelle les deux extrémités de l'étagère comportent un dispositif quelconque (4) destiné à coopérer avec un support placé sur le coffret.

8. Etagère selon la revendication 7, dans laquelle le dispositif de coopération avec un support est formé de pattes poinçonnées (4).

9. Etagère selon l'une quelconque des revendications précédentes, dans laquelle les surfaces en regard du corps principal (6) et du rabat ou de chaque rabat (7, 8) sont en butée lorsque l'étagère est montée dans le coffret si bien que l'étagère est maintenue rigide sans nécessiter un mécanisme d'accrochage entre le corps principal et le rabat ou chaque rabat.

10. Etagère selon la revendication 9, dans laquelle l'interface du corps principal (6) et du rabat ou chaque rabat articulé (7, 8) est inclinée si bien que, lorsque l'étagère est vue depuis l'avant, l'inclinaison est descendante et tournée vers l'intérieur.

11. Etagère selon l'une quelconque des revendications précédentes, dans laquelle l'axe correspondant le long duquel le rabat ou chaque rabat (7, 8) est articulé sur le corps principal (6) de l'étagère est décalé vers l'intérieur par rapport au bord du corps principal, et le rabat ou chaque rabat est muni à l'extrémité articulée d'un flasque qui s'étend vers l'axe correspondant d'articulation et est supporté de façon pivotante au niveau de cet axe.

12. Etagère selon l'une quelconque des revendications précédentes, dans laquelle le corps principal (6) a des saillies (13) sur une surface (11) tournée vers le rabat correspondant (7, 8) si bien que les saillies forment des points de contact lorsque l'étagère est installée dans un coffret.
